# EUROPÄISCHE PATENTSCHRIFT

(11) **EP 3 686 939 B1**
(45) Veröffentlichungstag und Bekanntmachung des Hinweises auf die Patenterteilung: **01.03.2023**
(21) Anmeldenummer: 20000002.4
(22) Anmeldetag: 02.01.2020
(51) Int. Cl.: H01L 31/0687, H01L 31/0304, H01L 31/0216, H01L 31/18

(54) **STAPELFÖRMIGE MEHRFACHSOLARZELLE**
MULTIPLE SOLAR CELL IN STACK DESIGN
CELLULE SOLAIRE MULTIPLE EMPILÉE

(30) Priorität: 28.01.2019 DE 102019000588
(43) Veröffentlichungstag der Anmeldung: 29.07.2020
(73) Patentinhaber: AZUR SPACE Solar Power GmbH, 74072 Heilbronn (DE)
(72) Erfinder: Meusel, Matthias, 74076 Heilbronn (DE); van Leest, Rosalinda, 74076 Heilbronn (DE); Berg, Alexander, 74074 Heilbronn (DE); Horst, Lilli, 74538 Rosengarten (DE)
(74) Vertreter: Koch Müller Patentanwaltsgesellschaft mbH

(56) Entgegenhaltungen:
- EP-A1- 2 966 692
- KR-A- 20110 081 387
- US-A1- 2010 218 819
- US-A1- 2017 200 845
- DONG-HWAN JUN ET AL: "Numerical Simulation of GaInP/AlInP Window Layer For High Concentration Photovoltaic Cells", AIP CONFERENCE PROCEEDINGS, 2010, Seiten 32-35, XP055513095, NEW YORK, US ISSN: 0094-243X, DOI: 10.1063/1.3509224

## Beschreibung

Die Erfindung betrifft eine stapelförmige Mehrfachsolarzelle.

Aus der DE 10 2013 209 217 A1 ist eine Mehrfachsolarzelle mit mehreren Teilzellen bekannt. Auf der obersten Teilzelle sind eine Fensterschicht und mehrere Metallfinger zur Ausbildung eines Vorderseitenkontakts und mehrere Antireflexschichten angeordnet.

Aus der der EP 2 966 692 A1 ist eine Mehrfachsolarzelle bekannt, wobei zwischen einer Fensterschicht und einer metallischen Kontaktschicht eine hochdotierte Halbleiterkontaktschicht angeordnet ist. Um einen Bandlückenunterschied zwischen der Fensterschicht und der Halbleiterkontaktschicht auszugleichen ist zwischen den Schichten eine weitere Halbleiterzwischenschicht angeordnet.

Aus Smith, B.L. et al.: "InAIAs photovoltaic cell design for high device efficiency", Progess in Photovoltaics: Research and Apllications, 25, 2017, S. 706 - 713 ist eine Mehrfachsolarzelle mit einer InAlAs-Topzelle, gefolgt von einer Fensterschicht, einer InP-Ätzstoppschicht und einer InGaAs-Kontaktschicht bekannt.

Aus der US 2010/218819 A1 ist ein Empfängerbaustein mit einer GaAs-Teilzelle und einer Fensterschicht bekannt, wobei auf der Fensterschicht und unterhalb einer p+-GaAs-Kontaktschicht ein oder zwei Zwischenschichten als Ätzstopp und/oder als Schutz für die Fensterschicht angeordnet ist.

Aus der KR 2011 00817 A ist eine einzelne Solarzelle mit einer AlInP-Fensterschicht und einer GaAs-Halbleiterkontaktschicht bekannt, wobei Oxidation der Fensterschicht durch eine zwischen der Halbleiterkontaktschicht und der Fensterschicht angeordnete Al-freie zweite Fensterschicht verhindert wird.

Eine Zwischenschicht zur Verhinderung von Oxidation auf der Fensterschicht ist ebenfalls aus Dong-Hwan Jun et al.: "Numerical Simulations of GaInP/AlInP Window Layer For High Concentration Photovoltaic Cells", AIP Converence Proceedings, 2010, S. 32-35l XP055513095, ISSN: 0094-243X, DOI; 10.1063/1.3509224 bekannt.

Vor diesem Hintergrund besteht die Aufgabe der Erfindung darin, eine Vorrichtung anzugeben, die den Stand der Technik weiterbildet.

Die Aufgabe wird durch eine stapelförmige Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfachsolarzelle bereitgestellt, mit einer ersten Teilzelle aufweisend eine Oberseite und eine Unterseite und einer zweiten Teilzelle.

Die erste Teilzelle ist als oberste Teilzelle ausgebildet, so dass einfallendes Licht erst auf die Oberseite der ersten Teilzelle und danach über die Unterseite auf die zweite Teilzelle auftrifft.

Zwischen der Unterseite der ersten Teilzelle und der zweiten Teilzelle ist eine erste Tunneldiode, angeordnet.

Mit einer Fensterschicht, wobei die Fensterschicht auf der Oberseite der ersten Teilzelle angeordnet ist und die Bandlücke der Fensterschicht größer ist als die Bandlücke der ersten Teilzelle.

Mindestens zwei zueinander beabstandete Metallfinger, wobei unterhalb der Metallfinger und oberhalb der Fensterschicht eine Abdeckschicht angeordnet ist.

Unterhalb der Abdeckschicht und oberhalb der Fensterschicht ist eine Zusatzschicht angeordnet.

Die Dicke der Zusatzschicht ist geringer als die Dicke der Fensterschicht und die Bandlücke der Zusatzschicht ist kleiner als die Bandlücke der Fensterschicht.

Es versteht sich, dass durch die Fensterschicht die Oberfläche der ersten Teilzelle konditioniert oder anders ausgedrückt, die Oberfläche passiviert wird, um hierdurch Rekombinationsverluste an der Grenzfläche zu verringern und den Wirkungsgrad der Mehrfachsolarzelle zu verbessern.

Es sei angemerkt, dass insbesondere zwischen den Metallfingern, d.h. der Bereich in dem das Licht auf die erste Teilzelle auftrifft, die Absorptionsverluste der Fensterschicht sehr gering oder möglichst Null sind. Hierzu weist das Material der Fensterschicht eine größere Bandlücke d.h. eine kleinere Gitterkonstante als das Material der ersten Teilzelle auf.

Des Weiteren ist es wünschenswert, dass zwischen den Metallfingern die Abdeckschicht möglichst vollständig entfernt ist, um zusätzliche Absorptionsverluste zu vermeiden. Anderseits ist es auch notwendig, die Dicke der Fensterschicht nicht zu verringern, um die Passivierung der Oberfläche der ersten Teilzelle nicht zu reduzieren.

Das Entfernen der Abdeckschicht zwischen den Metallfingern lässt sich vorzugsweise mittels nasschemischen Ätzverfahren durchführen.

Ein Vorteil einer ganzflächigen Ausbildung der Zusatzschicht zwischen der Fensterschicht und der Abdeckschicht während der Herstellung der Mehrfachsolarzelle ist, dass bei einem nasschemischen Rückätzen die zwischen den Kontaktfingern auf der Fensterschicht stoffschlüssig aufliegende Zusatzschicht als Ätzstoppschicht bzw. als Opferschicht bei dem Abätzen der Abdeckschicht dient.

Indem die Zusatzschicht im Vergleich zu der Ätzrate der Fensterschicht und auch im Vergleich zu der Ätzrate der Abdeckschicht nur eine sehr geringe Ätzrate aufweist, lässt sich die Ätzzeit zum Entfernen der Abdeckschicht verlängern und die Abdeckschicht zwischen den Metallfingern zuverlässiger als bisher entfernen und gleichzeitig einen Ätzangriff auf die Fensterschicht zu unterdrücken. Es versteht sich, dass in einer Weiterbildung die Abdeckschicht zwischen den Metallfingern vollständig oder wenigstens teilweise fehlt.

Indem die Zusatzschicht eine sehr geringe Ätzrate aufweist, lässt sich die Zusatzschicht wesentlich dünner als die Dicke der Fensterschicht und insbesondere wesentlich dünner als die Abdeckschicht ausbilden.

Es versteht sich hierbei, dass um zusätzliche Absorptionsverluste zu unterdrücken, die Dicke der Zusatzschicht möglichst gering und vorzugsweise nur so dick ausgeführt ist, um einen zuverlässigen Ätzstopp auszubilden und die darunterliegende Fensterschicht vor einem Ätzangriff zu schützen.

Erfindungsgemäß ist die Dicke der Zusatzschicht zwischen den Metallfingern geringer als unterhalb der Metallfinger. In einer Weiterbildung fehlt die Zusatzchicht zwischen den Metallfingern. Anders ausgedrückt, die Zusatzschicht wird bei dem Überätzen im Rahmen der Entfernung der Abdeckschicht ebenfalls vollständig entfernt, ohne jedoch die Fensterschicht anzugreifen.

Erfindungsgemäß weisen die Zusatzschicht und die Fensterschicht die gleichen Elemente, jedoch in einer unterschiedlichen Stöchiometrie auf.

In einer Ausführungsform ist die Gitterkonstante der Zusatzschicht größer als die Gitterkonstante der Fensterschicht. Des Weiteren ist die Gitterkonstante der Fensterschicht kleiner als die Gitterkonstante der ersten Teilzelle.

Erfindungsgemäß umfasst die Fensterschicht und die Zusatzschicht jeweils eine Verbindung mit wenigstens den Elementen In, Al, P oder die Fensterschicht und die Zusatzschicht bestehen aus InAlP.

Die Zusatzschicht weist im Vergleich zu der Fensterschicht einen höheren In-Anteil auf. Vorzugsweise weist die Zusatzschicht im Vergleich zu der Fensterschicht eine niedrigere Al-Konzentration auf. Beispielsweise besteht die Zusatzschicht aus In₆₈Al₃₂P. Vorzugsweise besteht die Fensterschicht aus In₅₈Al₄₂P.

Untersuchungen haben gezeigt, dass die Ätzrate bei der InAlP Verbindung mit einem zunehmenden Al-Gehalt proportional steigt, wobei sich eine InAlP Verbindung mit einem Al-Gehalt unterhalb 40% mit einer Mischung aus Zitronensäure, Wasserstoffperoxid und Wasser im Vergleich mit einem Al-Gehalt >50% nur sehr langsam ätzt.

In einer anderen Weiterbildung nicht Teil der Erfindung umfasst die Zusatzschicht eine Verbindung mit wenigstens den Elementen In, P oder die Zusatzschicht besteht aus InP.

In einer Ausführungsform umfasst die Abdeckschicht eine Verbindung mit wenigstens den Elementen Ga, As oder wenigstens mit den Elementen InGaAs oder die Abdeckschicht besteht aus GaAs oder InGaAs.

In einer Weiterbildung liegt die Dicke der Abdeckschicht in einem Bereich zwischen 30 nm und 1 µm oder die Dicke der Abdeckschicht liegt in einem Bereich zwischen 120 nm und 700 nm oder die Dicke der Abdeckschicht beträgt ca. 150 nm bei einer Anwendung für Konzentratoranwendungen oder ca. 500 nm bei einer Anwendung im Weltraum.

Es versteht sich, dass die Abdeckschicht eine elektrisch hohe Leitfähigkeit aufweist.

In einer Ausführungsform umfasst die Abdeckschicht eine GaAs Verbindung oder besteht aus einer GaAs Verbindung.

In einer anderen Weiterbildung weist die Zusatzschicht im Vergleich zu der Fensterschicht eine geringere nasschemische Ätzrate gegenüber einer Ätzlösung aus Zitronensäure, Wasserstoffperoxid und Wasser auf. Ein Vorteil ist, dass mittels der nasschemischen Selektivität sich die Zuverlässigkeit bei der Herstellung der Mehrfachsolarzelle verbessert.

Vorzugsweise weist die Zusatzschicht im Vergleich zu der Fensterschicht eine um einen Faktor 5 oder eine um den Faktor 10 oder um den Faktor 100 kleinere Ätzrate auf.

In einer anderen Weiterbildung weist die Zusatzschicht eine Dicke in einem Bereich zwischen 0,1 nm und 5 nm oder in einem Bereich zwischen 0,5 nm und 1,2 nm auf. Vorzugsweise beträgt die Dicke der Zusatzschicht genau 0,7 nm.

In einer Ausführungsform weist die Fensterschicht eine Dicke in einem Bereich zwischen 10 nm und 25 nm auf oder die Dicke der Fensterschicht liegt in einem Bereich zwischen 14 nm und 20 nm oder die Dicke der Fensterschicht liegt in einem Bereich zwischen 15 nm und 17 nm oder die Dicke der Fensterschicht beträgt 15 nm.

In einer Weiterbildung weist die Abdeckschicht und die Fensterschicht und die Zusatzschicht eine n-Dotierung mit den Dotierstoffen Si und / oder Te auf, wobei die Konzentration der Dotierstoffe größer als 5∗E17 N/cm³ und kleiner als 5∗E19 N/cm³ ist.

Es sei angemerkt, dass die vorliegende Mehrfachsolarzelle entweder ausschließlich Teilzellen aus einem III-V Material aufweist und / oder die unterste Teilzelle als Ge-Teilzelle ausgebildet ist. Des Weiteren sei angemerkt, dass die Mehrfachsolarzelle sowohl monolithisch ausgebildet ist, wobei die einzelnen Teilzellen zueinander gitterangepasst sind, als auch einen oder mehrere Halbleiterbonds aufweist.

Vorzugsweise weist die Mehrfachsolarzelle einen metamorphen Puffer zwischen einer untersten Teilzelle, aufweisend den kleinsten Bandabstand, und einer unmittelbar folgenden Teilzelle auf. Es versteht sich, dass die unmittelbar folgende Teilzelle einen größeren Bandabstand als die unterste Teilzelle aufweist.

Des Weiteren lässt sich die Mehrfachsolarzelle in einer aufrecht gewachsenen Form als sogenannte UMM-Mehrfachsolarzelle als auch in Form einer umgekehrt gewachsenen Mehrfachsolarzelle, d.h. als IMM-Mehrfachsolarzelle ausbilden.

In einer Ausführungsform umfasst die erste Teilzelle eine Verbindung mit wenigstens den Elementen In, P oder den Elementen In, Ga, P oder den Elementen Al, Ga, In, P oder die erste Teilzelle besteht aus InP oder aus InAlP oder aus InGaP oder aus AlGaInP.

Es sei angemerkt, dass die vorgenannten Verbindungen bei der ersten Teilzelle jeweils als Teil des Emitters oder Teil der Basis oder sowohl für den Emitter als auch für die Basis ausgebildet sind.

In einer anderen Weiterbildung umfasst die Mehrfachsolarzelle eine dritte Teilzelle und eine vierte Teilzelle, wobei jeweils zwischen zwei aufeinanderfolgenden Teilzellen immer eine weitere Tunneldiode ausgebildet ist. Vorzugsweise weist die Mehrfachsolarzelle genau vier Teilzellen auf.

Insbesondere ist bei der Vierfachzelle die erste Teilzelle als AlInGaP-Teilzelle, die zweite Teilzelle als AlInGaAs-Teilzelle und die dritte Teilzelle als InGaAs-Teilzelle und die vierte Teilzelle als Ge-Teilzelle ausgebildet.

In einer anderen Weiterbildung umfasst die Mehrfachsolarzelle eine dritte Teilzelle, eine vierte Teilzelle und eine fünfte Teilzelle. Vorzugsweise weist die Mehrfachsolarzelle genau fünf Teilzellen auf.

Insbesondere ist die erste Teilzelle als AlInGaP-Teilzelle, die zweite Teilzelle als InGaP-Teilzelle, die dritte Teilzelle als AlInGaAs-Teilzelle, die vierte Teilzelle als InGaAs-Teilzelle und die fünfte Teilzelle als Ge-Teilzelle ausgebildet.

Es versteht sich, dass zwischen zwei aufeinanderfolgenden Teilzellen jeweils eine Tunneldiode ausgebildet ist.

In einer Ausführungsform ist die Mehrfachsolarzelle als eine aufrecht monolithische Mehrfachsolarzelle ausgebildet.

In einer Weiterbildung ist bei der Mehrfachsolarzelle zwischen zwei Teilzellen ein Halbleiterspiegel ausgebildet. Ein Vorteil des Einbaus des Halbleiterspiegels ist es, dass bei einer Anwendung in der Raumfahrt die Strahlungshärte steigt und hierdurch der Endwirkungsgrad (EOL) steigt. Vorzugsweise ist der Halbleiterspiegel unterhalb einer InGaAs-Teilzelle und oberhalb einer Ge-Teilzelle eingebaut.

In einer Weiterbildung ist bei der Mehrfachsolarzelle zwischen zwei unmittelbar aufeinanderfolgenden Teilzellen ein metamorpher Puffer ausgebildet. Es versteht sich, dass sich der metamorphe Puffer und der Halbleiterspiegel gleichzeitig einbauen lässt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittsansicht auf eine erste erfindungsgemäße Ausführungsform einer Mehrfachsolarzelle,
- Figur 2: eine Querschnittsansicht auf eine zweite erfindungsgemäße Ausführungsform einer Mehrfachsolarzelle,
- Figur 3: eine Querschnittsansicht auf eine dritte erfindungsgemäße Ausführungsform einer Mehrfachsolarzelle.

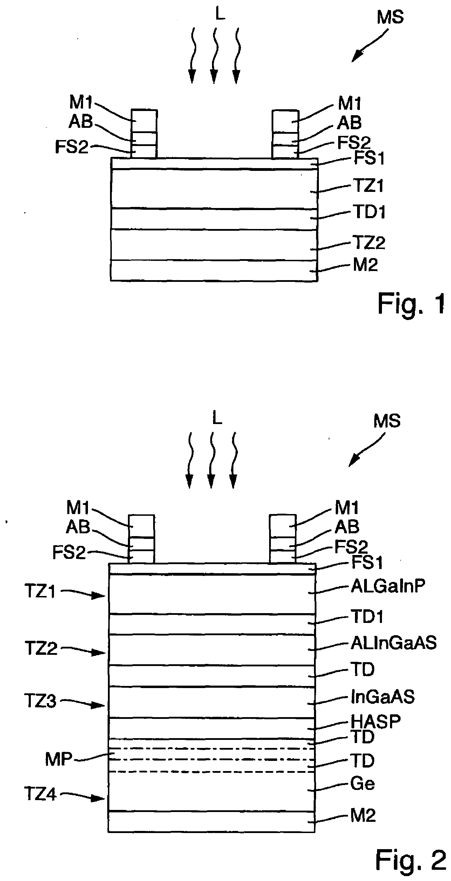

Die Abbildung der Figur 1 zeigt eine Ansicht einer ersten Ausführungsform, aufweisend eine Mehrfachsolarzelle MS mit einer ersten Teilzelle TZ1 und einer zweiten Teilzelle TZ2, wobei die erste Teilzelle TZ1 als oberste Teilzelle ausgebildet ist. Die erste Teilzelle TZ1 weist eine Oberseite und eine Unterseite auf.

Einfallendes Licht L trifft erst auf die Oberseite der ersten Teilzelle TZ1 und tritt danach an der Unterseite aus und trifft auf die zweite Teilzelle TZ2.

Zwischen der Unterseite der ersten Teilzelle TZ1 und der zweiten Teilzelle TZ2 ist eine erste Tunneldiode TD angeordnet. Unterhalb der zweiten Teilzelle TZ2 ist einer Metallschicht M2 ganzflächig mit einer Unterseite der zweiten Teilzelle TZ2 stoffschlüssig verbunden.

Auf der Oberseite der ersten Teilzelle TZ1 ist eine Fensterschicht mit einer Fensterschicht FS1 angeordnet. Oberhalb der Fensterschicht FS1 sind zwei zueinander beabstandete Metallfinger M1 angeordnet.

Unterhalb der Metallfinger M1 ist auf der Fensterschicht FS1 eine Zusatzschicht FS2 ausgebildet. Die Zusatzschicht FS2 weist eine unterschiedliche Stöchiometrie zu der Fensterschicht FS1 auf. Oberhalb der zweiten Fensterschicht FS2, aber unterhalb der Metallfinger M1, ist eine Abdeckschicht AB angeordnet.

In einer weiteren nicht dargestellten Ausführungsform ist auf der ersten Fensterschicht FS1 zwischen den Metallfingern M1 wenigstens eine geringe Dicke der zweiten Fensterschicht FS2 ausgebildet, wobei die Dicke der Zusatzschicht FS2 geringer als die Dicke der Zusatzschicht FS2 unterhalb der Metallfinger M1 ist.

In der Abbildung der Figur 2 ist eine Querschnittsansicht auf eine zweite erfindungsgemäße Ausführungsform einer Mehrfachsolarzelle MS dargestellt. Im Folgenden werden nur die Unterschiede zu der Abbildung der Figur 1 erläutert.

Die erste Teilzelle TZ1 umfasst oder besteht aus AlInGaP. Die zweite Teilzelle TZ2 umfasst oder besteht aus AlInGaAs. Unterhalb der zweiten Teilzelle TZ2 ist eine dritte Teilzelle TZ3 angeordnet. Die dritte Teilzelle TZ3 umfasst oder besteht aus InGaAs. Zwischen der zweiten Teilzelle TZ2 und der dritten Teilzelle TZ3 ist eine weitere Tunneldiode TD angeordnet.

Unterhalb der dritten Teilzelle TZ3 ist eine vierte Teilzelle TZ4 angeordnet. Die vierte Teilzelle TZ4 umfasst oder besteht aus Ge. Zwischen der dritten Teilzelle TZ3 und der vierten Teilzelle TZ4 ist eine weitere Tunneldiode TD angeordnet.

Optional ist zwischen der weiteren Tunneldiode TD und der dritten Teilzelle TZ3 ein Halbleiterspiegel HASP angeordnet, um die Strahlungshärte für Weltraumanwendungen zu erhöhen. Es versteht sich hierbei, dass für terrestrische Anwendungen der Halbleiterspiegel HASP entfällt.

In einer anderen Ausführungsform ist zwischen der dritten Teilzelle TZ3 und der vierten Teilzelle TZ4 ein metamorpher Puffer MP angeordnet, wobei die weitere Tunneldiode entweder zwischen dem metamorphen Puffer MP und der dritten Teilzelle TZ3 oder zwischen dem metamorphen Puffer MP und der vierten Teilzelle TZ4 angeordnet ist.

Anstelle der Anordnung der Metallschicht M2 unterhalb der zweiten Teilzelle TZ2 ist die Metallschicht M2 unterhalb der vierten Teilzelle TZ4 angeordnet und ganzflächig mit einer Unterseite der vierten Teilzelle TZ4 stoffschlüssig verbunden.

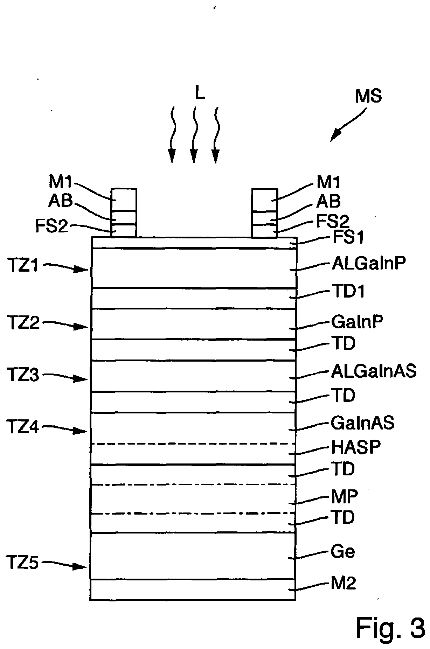

In der Abbildung der Figur 3 ist eine Querschnittsansicht auf eine dritte erfindungsgemäße Ausführungsform einer Mehrfachsolarzelle MS dargestellt.

Im Folgenden werden nur die Unterschiede zu der Abbildung der Figur 2 erläutert.

Die erste Teilzelle TZ1 umfasst oder besteht aus AlInGaP. Die zweite Teilzelle TZ2 umfasst oder besteht aus GaInP. Die dritte Teilzelle TZ3 umfasst oder besteht aus AlInGaAs.

Die vierte Teilzelle TZ4 umfasst oder besteht aus InGaAs. Unterhalb der vierten Teilzelle TZ4 ist eine fünfte Teilzelle TZ5 angeordnet. Die fünfte Teilzelle TZ5 umfasst oder besteht aus Ge.

Zwischen der vierten Teilzelle TZ4 und der fünften Teilzelle TZ5 ist eine weitere Tunneldiode TD angeordnet.

Optional ist zwischen der weiteren Tunneldiode TD und der vierten Teilzelle TZ4 ein Halbleiterspiegel HASP angeordnet, um die Strahlungshärte für Weltraumanwendungen zu erhöhen.

In einer anderen Ausführungsform ist zwischen der vierten Teilzelle TZ4 und der fünften Teilzelle TZ5 ein metamorpher Puffer MP angeordnet, wobei die weitere Tunneldiode TD entweder zwischen dem metamorphen Puffer MP und der vierten Teilzelle TZ4 oder zwischen dem metamorphen Puffer MP und der fünften Teilzelle TZS angeordnet ist.

Die Metallschicht M2 ist unterhalb der fünften Teilzelle TZ5 angeordnet und ganzflächig mit einer Unterseite der fünften Teilzelle TZ5 stoffschlüssig verbunden.

## Patentansprüche

1. Stapelförmige Mehrfachsolarzelle (MS), mit
- einer ersten Teilzelle (TZ1) aufweisend eine Oberseite und eine Unterseite und einer zweiten Teilzelle (TZ2), wobei die erste Teilzelle (TZ1) als oberste Teilzelle ausgebildet ist, sodass einfallendes Licht (L) erst auf die Oberseite der ersten Teilzelle (TZ1) und danach über die Unterseite auf die zweite Teilzelle (TZ2) auftrifft,
- einer ersten Tunneldiode (TD1), angeordnet zwischen der Unterseite der ersten Teilzelle (TZ1) und der zweiten Teilzelle (TZ2),
- einer Fensterschicht (FS1), wobei die Fensterschicht auf der Oberseite der ersten Teilzelle (TZ1) angeordnet ist und die Bandlücke der Fensterschicht (FS1) größer ist als die Bandlücke der ersten Teilzelle (TZ1),
- mindestens zwei zueinander beabstandete Metallfinger (M1), wobei unterhalb der Metallfinger (M1) und oberhalb der Fensterschicht (FS1) eine Abdeckschicht (AB) angeordnet ist,
unterhalb der Abdeckschicht (AB) und oberhalb der Fensterschicht (FS1) eine Zusatzschicht (FS2) angeordnet ist, wobei
die Dicke der Zusatzschicht (FS2) geringer ist als die Dicke der Fensterschicht (FS1) und die Bandlücke der Zusatzschicht (FS2) kleiner ist als die Bandlücke der Fensterschicht (FS1) und
- die Fensterschicht (FS1) und die Zusatzschicht (FS2) die gleichen Elemente, jedoch in einer unterschiedlichen Stöchiometrie aufweisen,
**dadurch gekennzeichnet, dass**
- die Dicke der Zusatzschicht (FS2) zwischen den Metallfingern (M1) geringer ist als unterhalb der Metallfinger (M1),
- die Fensterschicht (FS1) und die Zusatzschicht (FS2) jeweils eine Verbindung mit wenigstens den Elementen In, Al, P umfasst oder aus InAlP besteht und die Zusatzschicht (FS2) im Vergleich zu der Fensterschicht (FS1) eine höhere In-Konzentration und eine niedrigere Al-Konzentration aufweist.

2. Stapelförmige Mehrfachsolarzelle (MS) nach Anspruch 1, **dadurch gekennzeichnet, dass** die Gitterkonstante der Zusatzschicht (FS2) größer ist als der Gitterkonstante der Fensterschicht (FS1) und die Gitterkonstante der Fensterschicht (FS1) kleiner ist als die Gitterkonstante der ersten Teilzelle (TZ1).

3. Stapelförmige Mehrfachsolarzelle (MS) nach einem der vorangegangenen Ansprüche, **dadurch gekennzeichnet, dass** die Zusatzschicht (FS2) eine Verbindung mit wenigstens des Elementen In, P umfasst oder aus InP besteht.

4. Stapelförmige Mehrfachsolarzelle (MS) nach einem der vorangegangenen Ansprüche, **dadurch gekennzeichnet, dass** die Abdeckschicht (AB) zwischen den Metallfingern (M1) vollständig oder wenigstens teilweise fehlt.

5. Stapelförmige Mehrfachsolarzelle (MS) nach einem der vorangegangenen Ansprüche, **dadurch gekennzeichnet, dass** die Abdeckschicht (AB) eine Verbindung mit wenigstens den Elementen Ga, As oder wenigstens den Elementen In, Ga, As umfasst oder aus GaAs oder InGaAs besteht.

6. Stapelförmige Mehrfachsolarzelle (MS) nach einem der vorangegangenen Ansprüche, **dadurch gekennzeichnet, dass** die Dicke der Abdeckschicht (AB) in einem Bereich zwischen 30 nm und 1 µm liegt oder die Dicke der Abdeckschicht (AB) in einem Bereich zwischen 250 nm und 500 nm liegt oder die Dicke der Abdeckschicht (AB) 300 nm beträgt.

7. Stapelförmige Mehrfachsolarzelle (MS) nach einem der vorangegangenen Ansprüche, **dadurch gekennzeichnet, dass** die Zusatzschicht (FS2) im Vergleich zu der Fensterschicht (FS1) eine geringere nasschemische Ätzrate gegenüber einer Ätzlösung aus Zitronensäure, Wasserstoffperoxid und Wasser aufweist.

8. Stapelförmige Mehrfachsolarzelle (MS) nach einem der vorangegangenen Ansprüche, **dadurch gekennzeichnet, dass** die Zusatzschicht (FS2) eine Dicke aufweist und die Dicke der Zusatzschicht (FS2) in einem Bereich zwischen 0,1 nm und 5 nm oder die Dicke der Zusatzschicht (FS2) in einem Bereich zwischen 0,5 nm und 1,2 nm liegt oder die Dicke der Zusatzschicht (FS2) genau 0,7 nm beträgt.

9. Stapelförmige Mehrfachsolarzelle (MS) nach einem der vorangegangenen Ansprüche, **dadurch gekennzeichnet, dass** die Fensterschicht (FS1) eine Dicke aufweist und die Dicke der Fensterschicht (FS1) in einem Bereich zwischen 10 nm und 25 nm liegt oder die Dicke der Fensterschicht (FS1) in einem Bereich zwischen 14 nm und 20 nm liegt oder die Dicke der Fensterschicht (FS1) in einem Bereich zwischen 15 nm und 17 nm liegt oder die Dicke der Fensterschicht (FS1) 15 nm beträgt.

10. Stapelförmige Mehrfachsolarzelle (MS) nach einem der vorangegangenen Ansprüche, **dadurch gekennzeichnet, dass** die erste Teilzelle (TZ1) eine Verbindung aus den Elementen In, P oder aus den Elementen In, Ga, P aufweist oder die erste Teilzelle (TZ1) aus InP oder aus InAlP oder aus InGaP oder aus AlGaInP besteht.

11. Stapelförmige Mehrfachsolarzelle (MS) nach einem der vorangegangenen Ansprüche, **dadurch gekennzeichnet, dass** die Abdeckschicht (AB), und die Fensterschicht (FS1) und die Zusatzschicht (FS2) eine n-Dotierung mit den Dotierstoffen Si und / oder Te aufweist und die Konzentration der Dotierstoffe größer als 5∗E17 N/cm³ und kleiner als 5∗E19 N/cm³ ist.

12. Stapelförmige Mehrfachsolarzelle (MS) nach einem der vorangegangenen Ansprüche, **dadurch gekennzeichnet, dass** die Mehrfachsolarzelle (MS) eine dritte Teilzelle (TZ3) und eine vierte Teilzelle(TZ4) aufweist oder genau vier Teilzellen (TZ1, TZ2, TZ3, TZ4) aufweist, wobei jeweils zwischen zwei aufeinanderfolgenden Teilzellen (TZ2, TZ3, TZ4) immer eine weitere Tunneldiode (TD) ausgebildet ist.

13. Stapelförmige Mehrfachsolarzelle (MS) nach einem der vorangegangenen Ansprüche, **dadurch gekennzeichnet, dass** die Mehrfachsolarzelle (MS) fünf Teilzellen (TZ1, TZ2, TZ3, TZ4, TZ5) umfasst oder die Mehrfachsolarzelle (MS) genau aus fünf Teilzellen (TZ1, TZ2, TZ3, TZ4, TZ5) besteht, wobei jeweils zwischen zwei aufeinanderfolgenden Teilzellen (TZ2, TZ3, TZ4, TZ5) eine weitere Tunneldiode (TD) ausgebildet ist.

14. Stapelförmige Mehrsolarfachzelle (MS) nach einem der vorangegangenen Ansprüche, **dadurch gekennzeichnet, dass** die Mehrfachsolarzelle (MS) als eine monolithische Mehrfachsolarzelle (MS) ausgebildet ist.

15. Stapelförmige Mehrfachsolarzelle (MS) nach einem der vorangegangenen Ansprüche, **dadurch gekennzeichnet, dass** die Mehrfachsolarzelle (MS) zwischen zwei Teilzellen (TZ1, TZ2, TZ3, TZ4, TZ5) einen Halbleiterspiegel (HASP) aufweist.

16. Stapelförmige Mehrfachsolarzelle (MS) nach einem der vorangegangenen Ansprüche, **dadurch gekennzeichnet, dass** die Mehrfachsolarzelle (MS) zwischen zwei Teilzellen einen metamorphen Puffer aufweist.

## Claims

1. Stack-shaped multiple solar cell (MS), comprising
- a first part cell (TZ1) having an upper side and a lower side and second part cell (TZ2), wherein the first part cell (TZ1) is formed as uppermost part cell so that incident light (L) is incident firstly on the upper side of the first part cell (TZ1) and thereafter via the lower side on the second part cell (TZ2),
- a first tunnel diode (TD1) arranged between the lower side of the first part cell (TZ1) and the second part cell (TZ2),
- a window layer (FS1), wherein the window layer is arranged on the upper side of the first part cell (TZ1) and the band gap of the window layer (FS1) is greater than the band gap of the first part cell (TZ1),
- at least two metal fingers (M1) spaced from one another, wherein a cover layer (AB) is arranged below the metal fingers (M1) and above the window layer (FS1),
an additional layer (FS2) is arranged below the cover layer (AB) and above the window layer (FS1), wherein
the thickness of the additional layer (FS2) is less than the thickness of the window layer (FS1) and the band gap of the additional layer (FS2) is smaller than the band gap of the window layer (FS1) and
- the window layer (FS1) and the additional layer (FS2) comprise the same elements, but in a different stoichiometry,
**characterised in that**
- the thickness of the additional layer (FS2) between the metal fingers (M1) is less than below the metal fingers (M1),
- the window layer (FS1) and the additional layer (FS2) each comprise a compound with at least the elements In, Al, P or consist of InAlP and the additional layer (FS2) has a higher In concentration and a lower Al concentration by comparison with the window layer (FS1).

2. Stack-shaped multiple solar cell (MS) according to claim 1, **characterised in that** the lattice constant of the additional layer (FS2) is larger than the lattice constant of the window layer (FS1) and the lattice constant of the window layer (FS1) is smaller than the lattice constant of the first part cell (TZ1).

3. Stack-shaped multiple solar cell (MS) according to one of the preceding claims, **characterised in that** the additional layer (FS2) comprises a compound with at least the elements In, P or consists of InP.

4. Stack-shaped multiple solar cell (MS) according to any one of the preceding claims, **characterised in that** the cover layer (AB) is completely or at least partly absent between the metal fingers (M1).

5. Stack-shaped multiple solar cell (MS) according to any one of the preceding claims, **characterised in that** the cover layer (AB) comprises a compound with at least the elements Ga, As or at least the elements In, Ga, As or consists of GaAs or InGaAs.

6. Stack-shaped multiple solar cell (MS) according to any one of the preceding claims, **characterised in that** the thickness of the cover layer (AB) lies in a range between 30 nm and 1 µm or the thickness of the cover layer (AB) lies in a range between 250 nm and 500 nm or the thickness of the cover layer (AB) is 300 nm.

7. Stack-shaped multiple solar cell (MS) according to any one of the preceding claims, **characterised in that** the additional layer (FS2) has by comparison with the window layer (FS1) a lower wet-chemical etching rate relative to an etching solution of citric acid, hydrogen peroxide and water.

8. Stack-shaped multiple solar cell (MS) according to any one of the preceding claims, **characterised in that** the additional layer (FS2) has a thickness and the thickness of the additional layer (FS2) lies in a range between 0.1 nm or 5 nm or the thickness of the additional layer (FS2) lies in a range between 0.5 nm and 1.2 nm or the thickness of the additional layer (FS2) is exactly 0.7 nm.

9. Stack-shaped multiple solar cell (MS) according to any one of the preceding claims, **characterised in that** the window layer (FS1) has a thickness and the thickness of the window layer (FS1) lies in a range between 10 nm and 25 nm or the thickness of the window layer (FS1) lies in a range between 14 nm and 20 nm or the thickness of the window layer (FS1) lies in a range between 15 nm and 17 nm or the thickness of the window layer (FS1) is 15 nm.

10. Stack-shaped multiple solar cell (MS) according to any one of the preceding claims, **characterised in that** the first part cell (TZ1) comprises a compound of the elements In, P or of the elements In, Ga, P or the first part cell (TZ1) consists of InP or of InAlP or of InGaP or of AlGaInP.

11. Stack-shaped multiple solar cell (MS) according to any one of the preceding claims, **characterised in that** the cover layer (AB), the window layer (FS1) and the additional layer (FS2) have an n-doping with the doping substance or substances Si and/or Te and the concentration of the doping substances is greater than 5 • E17 N/cm³ and less than 5 • E19 N/cm³.

12. Stack-shaped multiple solar cell (MS) according to any one of the preceding claims, **characterised in that** the multiple solar cell (MS) comprises a third part cell (TZ3) and a fourth part cell (TZ4) or exactly four part cells (TZ1, TZ2, TZ3, TZ4), wherein a further tunnel diode (TD) is always formed between each two successive part cells (TZ2, TZ3, TZ4).

13. Stack-shaped multiple solar cell (MS) according to any one of the preceding claims, **characterised in that** the multiple solar cell (MS) comprises five part cells (TZ1, TZ2, TZ3, TZ4, TZ5) or the multiple solar cell (MS) consists of exactly five part cells (TZ1, TZ2, TZ3, TZ4, TZ5), wherein a further tunnel diode (TD) is formed between each two successive part cells (TZ2, TZ3, TZ4, TZ5).

14. Stack-shaped multiple solar cell (MS) according to any one of the preceding claims, **characterised in that** the multiple solar cell (MS) is constructed as a monolithic multiple solar cell (MS).

15. Stack-shaped multiple solar cell (MS) according to any one of the preceding claims, **characterised in that** the multiple solar cell (MS) has a semiconductor mirror (HASP) between two part cells (TZ1, TZ2, TZ3, TZ4, TZ5).

16. Stack-shaped multiple solar cell (MS) according to any one of the preceding claims, **characterised in that** the multiple solar cell (MS) has a metamorphic buffer between part cells.

## Revendications

1. Cellule solaire à jonctions multiples en forme de pile (MS) avec
- une première sous-cellule (TZ1) présentant une face supérieure et une face inférieure et une deuxième sous-cellule (TZ2), la première sous-cellule (TZ1) étant configurée comme la sous-cellule supérieure, de sorte que la lumière (L) pénètre en tombant d'abord sur la face supérieure de la première sous-cellule (TZ1) puis, via sa face inférieure, sur la deuxième sous-cellule (TZ2),
- une première diode tunnel (TD1) agencée entre la face inférieure de la première sous-cellule (TZ1) et la deuxième sous-cellule (TZ2),
- une couche fenêtre (FS1), laquelle couche fenêtre est agencée sur la face supérieure de la première sous-cellule (TZ1) et la bande interdite de la couche fenêtre (FS1) étant plus grande que la bande interdite de la première sous-cellule (TZ1), et
- au moins deux doigts métalliques (M1) écartés l'un de l'autre, une couche de recouvrement (AB) étant agencée au-dessous des doigts métalliques (M1) et au-dessus de la couche fenêtre (FS1) et
une couche supplémentaire (FS2) étant agencée au-dessous de la couche de recouvrement (AB) et au-dessus de la couche fenêtre (FS1),
l'épaisseur de la couche supplémentaire (FS2) étant inférieure à l'épaisseur de la couche fenêtre (FS1) et la bande interdite de la couche supplémentaire (FS2) étant plus petite que la bande interdite de la couche fenêtre (FS1) et
- la couche fenêtre (FS1) et la couche supplémentaire (FS2) présentant les mêmes éléments, mais dans une stoechiométrie différente,
**caractérisée en ce que**
- l'épaisseur de la couche supplémentaire (FS2) est plus faible entre les doigts métalliques (M1) qu'au dessous des doigts métalliques (M1) et que
- la couche fenêtre (FS1) et la couche supplémentaire (FS2) comprennent chacune un composé avec au moins les éléments In, Al et P ou sont constituées d'InAlP, la couche supplémentaire (FS2) présentant une concentration d'In plus importante et une concentration d'Al plus faible que la couche fenêtre (FS1).

2. Cellule solaire à jonctions multiples en forme de pile (MS) selon la revendication 1, **caractérisée en ce que** la constante de réseau de la couche supplémentaire (FS2) est supérieure à la constante de réseau de la couche fenêtre (FS1) et que la constante de réseau de la couche fenêtre (FS1) est inférieure à la constante de réseau de la première sous-cellule (TZ1).

3. Cellule solaire à jonctions multiples en forme de pile (MS) selon une des revendications précédentes, **caractérisée en ce que** la couche supplémentaire (FS2) comprend un composé avec au moins les éléments In et P ou est constituée d'InP.

4. Cellule solaire à jonctions multiples en forme de pile (MS) selon une des revendications précédentes, **caractérisée en ce que** la couche de recouvrement (AB) est totalement ou au moins partiellement absente entre les doigts métalliques (Ml).

5. Cellule solaire à jonctions multiples en forme de pile (MS) selon une des revendications précédentes, **caractérisée en ce que** la couche de recouvrement (AB) comprend un composé avec au moins les éléments Ga et As ou au moins les éléments In, Ga et As ou est constituée de GaAs ou d'InGaAs.

6. Cellule solaire à jonctions multiples en forme de pile (MS) selon une des revendications précédentes, **caractérisée en ce que** l'épaisseur de la couche de recouvrement (AB) est située sur une plage de 30 nm à 1 µm ou que l'épaisseur de la couche de recouvrement (AB) est située sur une plage de 250 nm à 500 nm ou que l'épaisseur de la couche de recouvrement (AB) est de 300 nm.

7. Cellule solaire à jonctions multiples en forme de pile (MS) selon une des revendications précédentes, **caractérisée en ce que** la couche de supplémentaire (FS2) présente une vitesse de gravure par voie humide plus faible que la couche fenêtre (FS1) face à une solution de gravure constituée d'acide citrique, de peroxyde d'hydrogène et d'eau.

8. Cellule solaire à jonctions multiples en forme de pile (MS) selon une des revendications précédentes, **caractérisée en ce que** la couche supplémentaire (FS2) présente une épaisseur et que l'épaisseur de la couche supplémentaire (FS2) est située sur une plage de 0,1 nm à 5 nm ou que l'épaisseur de la couche supplémentaire (FS2) est située sur une plage de 0,5 nm à 1,2 nm ou que l'épaisseur de la couche de supplémentaire (FS2) est exactement de 0,7 nm.

9. Cellule solaire à jonctions multiples en forme de pile (MS) selon une des revendications précédentes, **caractérisée en ce que** la couche fenêtre (FS1) présente une épaisseur et que l'épaisseur de la couche fenêtre (FS1) est située sur une plage de 10 à 25 nm ou que l'épaisseur de la couche fenêtre (FS1) est située sur une plage de 14 nm à 20 nm ou que l'épaisseur de la couche fenêtre (FS1) est située sur une plage de 15 nm à 17 nm ou que l'épaisseur de la couche fenêtre (FS1) est de 15 nm.

10. Cellule solaire à jonctions multiples en forme de pile (MS) selon une des revendications précédentes, **caractérisée en ce que** la première sous-cellule (TZ1) comporte un composé constitué des éléments In et P ou des éléments In, Ga et P ou que la première sous-cellule (TZ1) est constituée d'InP ou d'InAlP ou d'InGaP ou d'AlGalnP.

11. Cellule solaire à jonctions multiples en forme de pile (MS) selon une des revendications précédentes, **caractérisée en ce que** la couche de recouvrement (AB), la couche fenêtre (FS1) et la couche supplémentaire (FS2) présentent un dopage n avec les agents de dopage Si et/ou Te et que la concentration des agents de dopage est supérieure à 5•E17 N/cm³ et inférieure à 5•E19 N/cm³.

12. Cellule solaire à jonctions multiples en forme de pile (MS) selon une des revendications précédentes, **caractérisée en ce que** cette cellule solaire à jonctions multiples (MS) comporte une troisième sous-cellule (TZ3) et une quatrième sous-cellule (TZ4) ou comporte exactement quatre sous-cellules (TZ1, TZ2, TZ3, TZ4), une diode tunnel (TD) supplémentaire étant toujours formée entre deux sous-cellules successives (TZ2, TZ3, TZ4).

13. Cellule solaire à jonctions multiples en forme de pile (MS) selon une des revendications précédentes, **caractérisée en ce que** cette cellule solaire à jonctions multiples (MS) comporte cinq sous-cellules (TZ1, TZ2, TZ3, TZ4, TZ5) ou est constituée exactement de cinq sous-cellules (TZ1, TZ2, TZ3, TZ4, TZ5), une diode tunnel (TD) supplémentaire étant toujours formée entre deux sous-cellules successives (TZ2, TZ3, TZ4, TZ5).

14. Cellule solaire à jonctions multiples en forme de pile (MS) selon une des revendications précédentes, **caractérisée en ce que** cette cellule solaire à jonctions multiples (MS) est configurée comme une cellule solaire à jonctions multiples (MS) monolithique.

15. Cellule solaire à jonctions multiples en forme de pile (MS) selon une des revendications précédentes, **caractérisée en ce que** cette cellule solaire à jonctions multiples (MS) comporte un miroir semi-conducteur (HASP) entre deux sous-cellules (TZ1, TZ2, TZ3, TZ4, TZ5).

16. Cellule solaire à jonctions multiples en forme de pile (MS) selon une des revendications précédentes, **caractérisée en ce que** cette cellule solaire à jonctions multiples (MS) comporte un tampon métamorphique entre deux sous-cellules.
